Europäisches Patentamt

European Patent Office

Office européen des brevets

(19)

(11) Publication number: **0 274 421**
**A2**

(12) **EUROPEAN PATENT APPLICATION**

(21) Application number: **88300053.1**

(22) Date of filing: **05.01.88**

(51) Int. Cl.⁴: **H 01 L 39/14**
**H 01 L 39/12**

(30) Priority: **09.01.87 US 1682**

(43) Date of publication of application:
**13.07.88 Bulletin 88/28**

(84) Designated Contracting States:
**AT BE CH DE ES FR GB GR IT LI NL SE**

(71) Applicant: **AMERICAN TELEPHONE AND TELEGRAPH COMPANY**
**550 Madison Avenue**
**New York, NY 10022 (US)**

(72) Inventor: **Batlogg, Bertram Josef**
**308 Livingston Avenue**
**New Providence New Jersey 07974 (US)**

**van Dover, Robert Bruce**
**300 Emerson Lane**
**Berkeley Heights New Jersey 07922 (US)**

**Cava, Robert Joseph**
**193D Lakeview Drive, RD2**
**Basking Ridge New Jersey 07920 (US)**

(74) Representative: **Johnston, Kenneth Graham et al**
**AT&T (UK) LTD. AT&T Intellectual Property Division 5**
**Mornington Road**
**Woodford Green Essex, IG8 0TU (GB)**

(54) Device and systems based on novel superconducting material.

(57) A class of superconductive materials containing copper-oxygen bonding and with mixed cation-occupancy designed with a view to size and valence consideration yield useful values of critical temperature and other properties. Uses entail all applications which involves superconducting materials such as magnets and transmission lines which require continuous superconductivity paths as well as detectors (e.g., which may rely on tunneling).

EP 0 274 421 A2

**Description**

DEVICES AND SYSTEMS BASED ON NOVEL SUPERCONDUCTING MATERIAL

## Background of the Invention

This invention relates to superconductive material and apparatus and systems utilizing such material. Characteristics of preferred compositions herein give rise to apparatus design advantages. Such characteristics include useful values of critical temperature and critical magnetic field. Certain of the compositions are free of characteristics which have been associated with radiation damage in prior materials.

The field of superconductivity has had a varied history from its beginnings -- from the discovery of the phenomenon by Kamerlingh Onnes in 1911. Implications of extreme practical significance were apparent from the start. Workers became enchanted with the thought of lossless transmission as well as implications on magnetic and other apparatus. The concept that has received so much attention in recent years -- that of "permanent" magnets of extremely high field values useful e.g. for containment of fusion reactions -- was not overlooked.

Advances in obtaining material with improved properties have been discontinuous. Experiments following the first discovery, while certainly substantiating the concept, established need for extremely low temperatures, i.e., low values of transition temperatures, $T_c$. Mercury ($T_c \sim 4K$) was discovered first, and lead ($T_c \sim 7K$) was discovered to be superconducting shortly thereafter.

There was little achievement either experimentally or in theoretical terms following the initial period until the 1940's when work on NbN yielded a $T_c$ value of about 16K. Evolution and description of the concept was not broadly and effectively disseminated because of its German origin and circumstances surrounding World War II. A significant period of inquiry began subsequent to World War II. From the mechanistic standpoint, the most significant advance entailed identification of Type II superconductivity (Ginzberg and Landau, 20 Zh. Eksperim. i Teor.Fiz., pg. 1064 (1950)).

From a mechanistic-theoretical standpoint 1957 marks a most significant advance in understanding of superconductivity. The Bardeen Cooper Schrieffer Theory (for which a Nobel prize was subsequently awarded), (108 *Phys. Rev.,* pg. 1175 (1957) gave rise to the understanding which has been implicit in all studies to the present time. Intensive worldwide effort was established by the activity of B. T. Matthias of Bell Laboratories and J. K. Hulm of Westinghouse resulting in the most significant A15 compounds exemplified by $Nb_3Sn$. This was followed by identification of the members as well as of related alloy compositions generally containing Nb. This work gave renewed hope of practical applications working with a refrigerant more effective than liquid helium. Materials developed during this period continue to be studied extensively, and indeed serve very significant technological functions, e.g., in particle accelerations.

Efforts to develop materials with significantly higher values of ($T_c$ than $Nb_3SnT_c = 18$ K) were disappointing. Probably the culmination was the $T_c$ value of $\sim 23.2$ K for $Nb_3Ge$ in 1973 by L. Testardi at Bell Laboratories and J. R. Gavaler at Westinghouse.

The subsequent decade resulted in little advance in terms of $T_c$. Extensive study of a new category of material was, however, very important and plays a vital role in development of this invention. This study entailed compositions of barium bismuth lead oxide ($BaPb_{1-x}Bi_xO_3$). B. Batlogg, *Physica 126B,* 275 (1984). Most significant, compositions in this category while attaining $T_c$ values of only up to 13K depended upon metal-oxygen bonding for superconductivity.

Most recent origins of the present invention are traceable to the extremely significant work reported by IBM Zurich -- J. G. Bednorz and K. A. Muller (64 Z. Phys. B. - Condensed Matter, pp. 189 (1986)). Report of onset $T_c$ values in the 30K range stimulated intense activity by a number of groups worldwide. Some related subsequent developments were reported in the New York Times for Wednesday, December 31, 1986. Such reported work generally concerns the significance of preparatory conditions as well as refined measurements of the prototypical composition system reported by IBM.

The invention takes the primary form of compositional modifications of the IBM system. These modifications arose from an intimate understanding of the superconducting mechanism largely based on extensive work done in the $Ba(Pb,Bi)O_3$ system. Substitutions are characterized as having two-fold significance: 1) substituents are chosen to produce a more compact structure (the unit cell is reduced from typical 23° C, 1 atmosphere dimensions in the prototypical material (of $a_o = 3.8$ A or, more generally

$$\frac{a_o + b_o}{2} = 3.8 \ \text{A}$$

and $C_o = 13.29$ A) to smaller values, e.g., in the inventive compositions, 2) with a view to valence implications --with respect to the prototypical compositions, to increase the quantity of $Cu^{3+}$ relative to $Cu^{2+}$. Both implications are determined to be significant and in turn to serve to designate preferred categories. An additional preferred class undergoes a structural transition from tetragonal to orthorhombic, usually at some reduced temperature prior to attainment of superconductivity.

Experimental work which forms a part of this invention involve incorporation of strontium and/or calcium as substitution for barium with the purpose of producing the more compact structure. Such substitutions were premised on reported effective radii (R. Shannon and C. Prewett, *B25 Acta Cryst.* 925 (1969). Realization of the desired improvement suggested other approaches to increase compactness, e.g., application of axial or hydrostatic pressure, the latter as subsequently verified in the New York Times report.

Inventive implications apply to essentially all superconducting apparatus. The inventive findings have already provoked restudy of long-distance power transmission now made possible at liquid hydrogen temperatures. Other implications, of course, arise from the higher values of critical field with implications to fusion reaction containment, for example. Such purposes are consistent with materials characterized by continuous superconducting paths. Other purposes also well known to prior workers include use in devices such as detectors and those dependent on tunneling phenomena such as Josephson junction devices as well as other devices which depend on weakly coupled superconductors and/or in the large value of the superconducting gap.

## Brief Description of the Drawings

FIG. 1 is a diagrammatic representation of the general crystal class to which compositions of the invention belong. As described further on, it serves as a basis both for the tetragonal phase which generally typifies compositions herein at higher temperatures as well as derived structures which may entail distortions to orthorhombic symmetry,

FIGS. 2 and 3, on coordinates of resistivity ratio and temperature, plots characteristic of materials made in accordance with the Examples. The curve form is useful in identification of the various values of $T_c$.

FIGS. 4 and 5, on coordinates of magnetization and temperature, show development of (superconductive) diamagnetic response, again, as plotted for typical materials produced in accordance with the Examples,

FIG. 6 depicts a cable design incorporating a superconducting element of an inventive composition,

FIG. 7 depicts a superconducting solenoid,

FIG. 8 represents a superconducting torus suitable for use for fusion reaction confinement,

FIG. 9 is a plot which depicts the IV characteristic of the Josephson junction device shown schematically in FIG. 10; and

FIG. 10 shows a Josephson junction device illustrative of devices dependent upon superconducting tunneling.

## Detailed Description

Compositions of the invention are most conveniently described by reference to the prototypical composition $La_{2-x}Ba_xCuO_4$, in which $x$ is at least 0.05. In these terms, the inventive advance takes the form of improvement realizable from an increase in compactness in the unit cell. In a preferred embodiment, this takes the form of inclusion of strontium and/or calcium substituted for barium in a quantity of at least 10 at. % of the barium. Preferred compositions depend upon greater amounts of Sr and/or Ca with greatest increase in $T_c$ being realized for total substitution (i.e., $La_{2-x}(Sr$ and/or $Ca)_xCuO_4$). Experimental work represented herein establishes that the compound can exist with an oxygen deficiency (in terms of the formulae set forth). Accordingly, the compositional class is appropriately represented as $La_{2-x}M_xCuO_{4-\delta}$ with M = (strontium and/or calcium).

As will be seen from the Examples, other variations in composition may result in retention of useful superconducting properties. For example, partial substitution of Pr or Y for lanthanum, despite the magnetic nature of one of these substituents, resulted in material which, while of slightly reduced $T_c$, nevertheless manifests true superconducting behavior. Other substitutions, e.g., partial substitution of tin for copper, were also effective.

Material specification in accordance with the invention depends upon the nature of the intended use. For power transmission, or any other current-carrying application, it is required that there be a continuous superconducting path. For detector and other device use (e.g., Josephson junction devices) in which tunneling might be permitted or even required, it is necessary only that there be sufficient superconducting phase to satisfy such use.

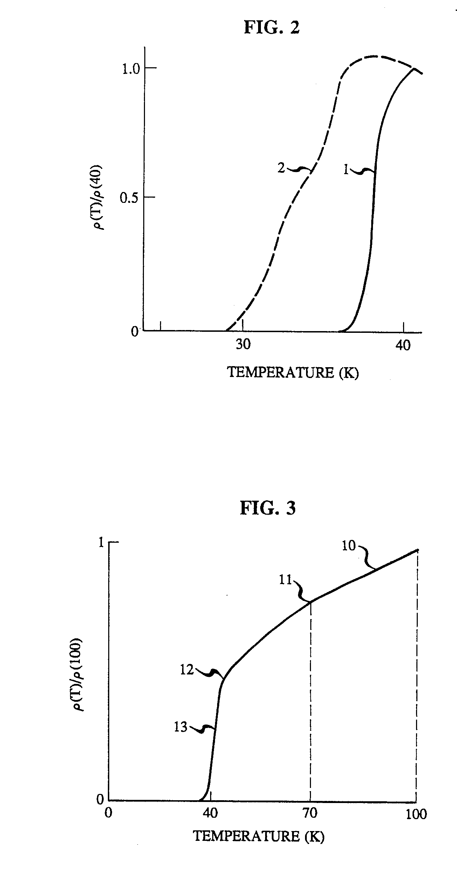

Significant anomalies in the resistance/temperature relationship as well as in the magnetization/temperature relationship suggest occurrence of a superconducting phase of somewhat different characteristics. As is seen from the FIG. 3, one such anomaly at about 70 K may be of significant device consequence. Existence of such a phase within a conducting path may, in some instances, be used to advantage. A class of compositions found particularly desirable in terms of $T_c$ values may be defined as $La_{2-x}(Sr$ and/or $Ca)_xCuO_{4-\delta}$ in which $x$ is from 0.1 to 0.3. As discussed, superconducting elements in accordance with the invention may be made up in their entirety of such compositions or may include other (superconducting or non-superconducting) material depending upon use.

Introduction of the $\delta$ term is quite significant. It defines, in part, (together with $x$) relative amounts of $Cu^{3+}$ and $Cu^{2+}$ (as well as of Cu substituents in the general formula) found to affect $T_c$. $\delta$ variation is expeditiously accomplished by prescription of processing conditions discussed later on.

It has been noted that the origins of the work concern a material of conventional tetragonal symmetry. It is considered significantly that a class of materials of this invention are seen to undergo distortion to orthorhombic symmetry -- sometimes with decreasing temperature but likely at temperatures above $T_c$. It is appropriate to described all materials of this invention as being tetragonal or of structure recognized as distortions of tetragonal symmetry. Distortions measured on the basis of usual x-ray techniques may be as small as one part in a thousand. Such magnitudes are considered to be of significance.

For many purposes, it is an advantage of the invention that fabrication of superconducting elements may utilize standard ceramic processing.

Appropriate starting materials are mixtures of metallic oxides, hydroxides, carbonates, hydrates, oxilates or other reactive precursors in the appropriate ratio to obtain the desired final composition. Starting material may be produced by wet or dry mixing by co-precipitation of materials from solution or, by any other method which results in intimate mixture of reactive particles.

Mixtures of starting materials can be fired in air, oxygen or other non-reducing ambient at temperatures sufficient to facilitate chemical; reaction between constituents and to begin formation of the desired phase. Typical firing temperatures are between approximately 700 and 1100 C for times of between a few hours and several days until the desired phase is either fully or partially produced. The "calcined" material is then formed into the ceramic body of desired shape by standard ceramic processing techniques such as hot or cold pressing, extrusion, slipcasting, or other such technique appropriate to the geometry of the desired (green body) object.

The material in final form is fired at a temperature sufficiently high to complete chemical reaction of components ("reactive sintering") if not accomplished in step (2) and for densification. This "sintering" is conducted so as to reduce voids to the point where the density of the ceramic body is sufficient to allow obtaining favorable electrical and mechanical properties. For most favorable electrical properties, the material is fired in an ambient environment with greater partial pressure of $O_2$ than air greater than (.2 at.). However, material fired in air also has acceptable superconducting properties for many purposes.

While the description above is important for many purposes, material preparation may take other forms. An alternative is preparation of thin films for Josephson junction and other devices. Workers in the field known of many film-forming procedures, e.g., magnetron sputtering, diode sputtering, reactive ion sputtering, ion-beam sputtering and other thin film deposition techniques including evaporation. "Conductor" structures may take on the form of continuous strands, however produced. Initial formation may utilize techniques as applied to other brittle glass-like material. In this approach, the structure reverts to one that is crystalline before attainment of superconductivity). One technique which has been applied to other brittle superconductors entails extrusion within a protective sheathing of copper or other ductile material.

Since the material is oxidic another approach may entail formation of an alloy of the designated metals followed by oxidation.

## Generalized Preparatory Approach As Used in the Examples

Here the procedure followed in each of the numbered examples is set forth:

1) starting materials are powders of lanthanum hydroxide, strontium carbonate, calcium oxide, copper oxide, praeseodymiun oxide, yttrium oxide, bismuth oxide, and tin oxide. While much of the work entailed relative high purity, the lanthanum hydroxide used contained finite amounts of other rare earths known to be difficult to remove. As shown in Example 5, incorporation of magnetic praeseodymiun did not preclude superconductivity (it resulted only in some depression of $T_c$). It is noteworthy that high purities are not required for preparation of suitable material.

2) starting materials are weight in appropriate quantities to yield the desired composition. They are then further pulverized in a mortar and pestle.

3) materials from step 2 are then fired (for comparison purposes reported examples used an ambient temperature of 850° C for a period of approximately 16 hours).

4) materials are repulverized with a mortar and pestle and then refired in air or oxygen (again to expedite comparison, a fixed temperature of ~1,000° C for a period of approximatley 16 hours was used).

5) The procedure of step 4 is then repeated.

6) Materials are pulverized and pressed dry into shape suitable for experimentation at a pressure of between 5,000 and 10,000 psi. (In the examples reported the shape was that of a disc of approximately 1 cm diameter and 1mm thick.

7) The discs are next fired in accordance with the schedule:

   a) temperature of 900° C for two hours in oxygen,
   b) temperature of 1100° C for four hours in oxygen,
   c) temperature of 900° C for 16 hours in oxygen,
   d) temperature of 700° C for 16 hours in oxygen.

8) Materials are allowed to cool to ambient room temperature in flowing oxygen gas.

As stated, the above conditions were for purpose of comparison. Other preliminary work has established value in of varying many of the conditions set forth. For example, the repeating of step 4 to assure a degree of uniformity can be omitted -- may even desirably be omitted. Clearly, the temperatures stated are non-critical, the requirement being only that the required composition-phase is produced in sufficient quantity as described. Consistent with the description above, other considerations may dictate deliberate abbreviation in processing to avoid production of pure single-phase material.

In FIG. 2 curves represent variation in properties due to the nature of the ambient during firing. Most pronounced effect is realized by control of this atmosphere during final annealing.

The technique used to identify the nature of the final material is set forth: a portion of the finally annealed disc is pulverized, and a powder X-ray diffraction pattern is made. The particular technique used was powder diffractometry, although other techniques such as Debye-Scherrer or Guinier photography may also be employed. (B. D. Cullity, *Elements of X-Ray Diffraction,* Addison-Wesley Publ. Co., Inc., Reading, Mass (1978)).

The Examples

Reported examples are set forth in tabular form with all unspecified conditions in conformance with the generalized procedure outlined above.

TABLE 1:

## STARTING MATERIALS (WEIGHT FRACTIONS)

| | Composition | $La(OH)_3$ | $SrCO_3$ | CuO | CaO | $Y_2O_3$ | $Pr_6O_{11}$ |
|---|---|---|---|---|---|---|---|
| 1. | $La_{1.85}Sr_{.15}CuO_4$ | .7756 | .0489 | .1756 | | | |
| 2. | $La_{1.8}Sr_{.2}CuO_4$ | .7581 | .0655 | .1764 | | | |
| 3. | $La_{1.75}Sr_{.25}CuO_4$ | .7406 | .0823 | .1772 | | | |
| 4. | $La_{1.75}Ca_{.15}Sr_{.1}CuO_4$ | .7639 | .0339 | .1828 | .0193 | | |
| 5. | $La_{1.45}Pr_{.4}Sr_{.15}CuO_4$ | .6084 | .0654 | .1757 | | | .1504 |
| 6. | $La_{1.5}Y_{.3}Sr_{.2}CuO_4$ | .6659 | .0690 | .1859 | | .0792 | |

Properties

Description of transition temperatures $T_c$ in the literature has not been free of ambiguity. Frequently measured results are in terms of: (1) ($T_c$ onset) what is is usually called "onset temperature" which is in itself ambiguous. The term is intended to signify the first anomaly in a measured characteristic indicative of superconductivity (examples include variations in the slope of resistivity v temperature, decrease of magnetic susceptibility, etc), (2) ($T_c$ midpoint) the resistive midpoint i.e. the resistance value which is 1/2 that of the onset and absolute zero values, (3) ($T_cR=0$) more meaningful measure directly indicative of true superconductivity, i.e. resistive-less conduction of current (zero resistance), electrical resistance, and (4) ($T_cM$) the most stringent measure (as reported herein) involving the expulsion of magnetic flux. (By this technique the fraction of the volume which superconducting may be is determined.)

Materials produced in accordance with the examples were found to have the following values of $T_c$. (Many of the materials prepared in the examples were measured by more than one of the described techniques as indicated above).

In all instances reported in the examples, product was established as being of the tetragonal or distorted tetragonal (orthorhombic) structure as described. Again, for comparative purposes, it was found useful to select examples in which the sample was substantially single-phase.

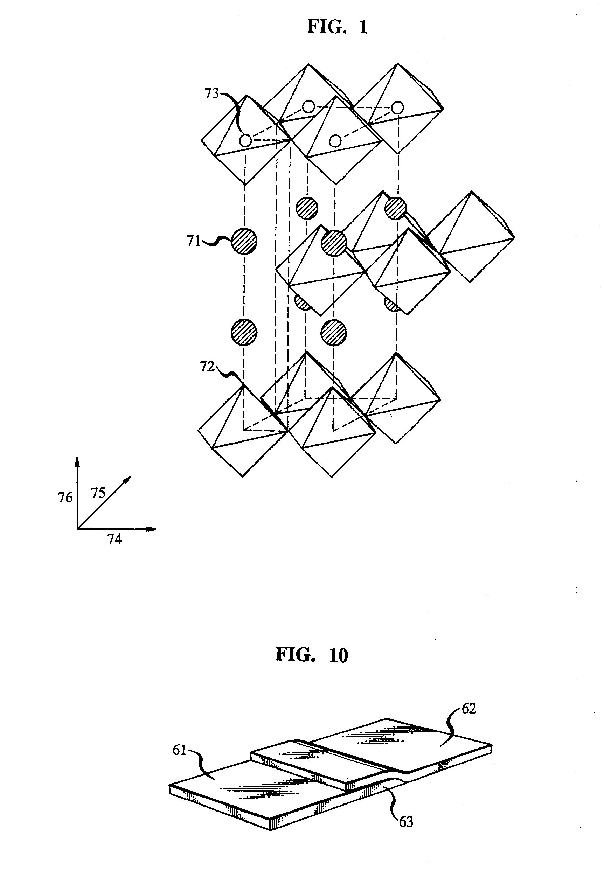

FIG. 1 presents the atomic arrangement of the unit cell of materials of the $K_2NiF_4$ structure type. The structure has been described in detail in standard reference. The symbols of the type marked by 71 are representative of the positions of the La and Ba atoms in the prototype material; symbols of the type marked by 72 are representative of the oxygen atoms; and symbols of the type marked 73 are representative of the copper atoms. The unit cell represented has tetragonal symmetry, that is, that the elementary repeat distances in the directions denoted by arrows marked 74 and 75 are equal in length to each other, and unequal in length from the repeat distance in the direction represented by the arrow marked 76. In orthorhombic distortions of this structure, the elementary repeat distances in the directions of the arrows marked 74 and 75 become unequal to each other, due to small changes in the position of some or all of the atoms. In both the tetragonal and orthorhombic structures, the directions denoted by arrows 74 through 76 are at right angles to each other.

TABLE 2:

SUPERCONDUCTING TRANSITION TEMPERATURES FOR EXAMPLE MATERIALS

| Example | Composition | $T_c^{onset}$ | $T_c^{midpoint}$ | $T_c^{R=0}$ | $T_c^M$ |
|---|---|---|---|---|---|
| 1. | $La_{1.85}Sr_{0.15}CuO_4$ | 40.0 | 38.2 | 37.5 | 37.5 |
| 2. | $La_{1.8}Sr_{0.20}CuO_4$ | 38.5 | 36.3 | 34.5 | 36 |
| 3. | $La_{1.75}Sr_{0.25}CuO_4$ | | | | 35 |
| 4. | $La_{1.75}Sr_{0.10}Ca_{0.15}CuO_4$ | 42.0 | 35.8 | 34.0 | |
| 5. | $La_{1.45}Pr_{0.40}Sr_{.15}CuO_4$ | 35.8 | 33.7 | 32.0 | |
| 6. | $La_{1.50}Y_{0.30}Sr_{0.20}CuO_4$ | 39.8 | 33.7 | 30.0 | |

FIGS. 2 and 3 are illustrative of the resistive technique for measuring superconductivity. In both instances, the resistivity measurement $\rho$ is made by standard 4-point probe. In both instances, abscissa units are temperature in Kelvin, K. In FIG. 2, ordinate units are normalized in terms of resistivity at 40K. In the instance of FIG. 2, the solid line 1 corresponds with Example 2. The dashed line 2 relates to the same composition prepared under identical circumstances except that the final oxygen firing atmosphere was replaced by air, the steeper slope indicating greater homogeneity as well as higher values of $T_c$ (as seen from the Table). Generally, substitution of oxygen is seen to increase $T_c$ as through adjustment of the $Cu^{3+}$-$Cu^{2+}$ ratio. FIG > 3, in ordinate units of resistivity, in this instance normalized at 100 K, corresponds with Example 1. It is seen that curve 10 follows a constant slope upon decrease temperature to about 70 K at which there is a first break 11. Further decrease in temperature shows the usual curve form of decrease in slope with a significant change in slope at 12 and final intersection at the abscissa at about 37.2 K. Point 11, showing an anomaly at about 70 K, may be interpreted as the onset of superconductivity. Point 12, for purposes herein, is considered descriptive of the more significant onset temperature since relating to the primary superconducting phase. Point 13 is the "mid-point resistive" value as reported in the Table -- in this instance occurring at 38 K.

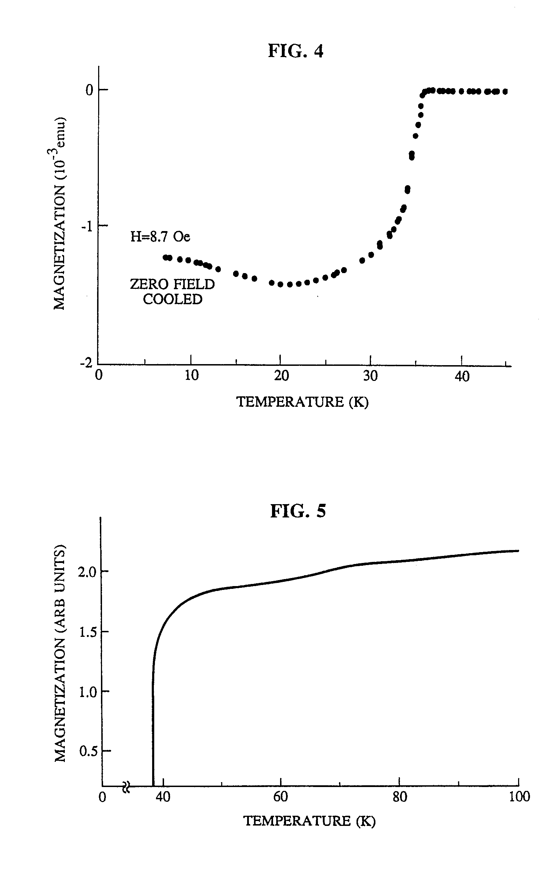

FIGS. 4 and 5, in units of magnetization on the ordinate in terms of milli-emu versus temperature in Kelvin on the abscissa, are illustrative of the results of magnetization measurements. The particular sample are that of Examples 2 and 1, respectively. The procedure followed for this Example and for all others reported involved first cooling the sample to 4 K, a magnetic field was then applied and the temperature increased while measuring the magnetization used in a commercial SQUID magnetometer. For the particular sample plotted, the field applied was 8.7 Oe. resulting in a magnetization which varied from a level of -1.2 which decreased through a minimum value and sharpley turned up at about 35 K.

FIG. 5, in arbitrary magnetization on the ordinate and temperature in Kelvin on the abscissa, follows a similar behavior for a different sample (Example 1). The purpose of this FIG. is to show the anomalous behavior at a temperature of about 70 K (substantially above the more marked onset temperature).

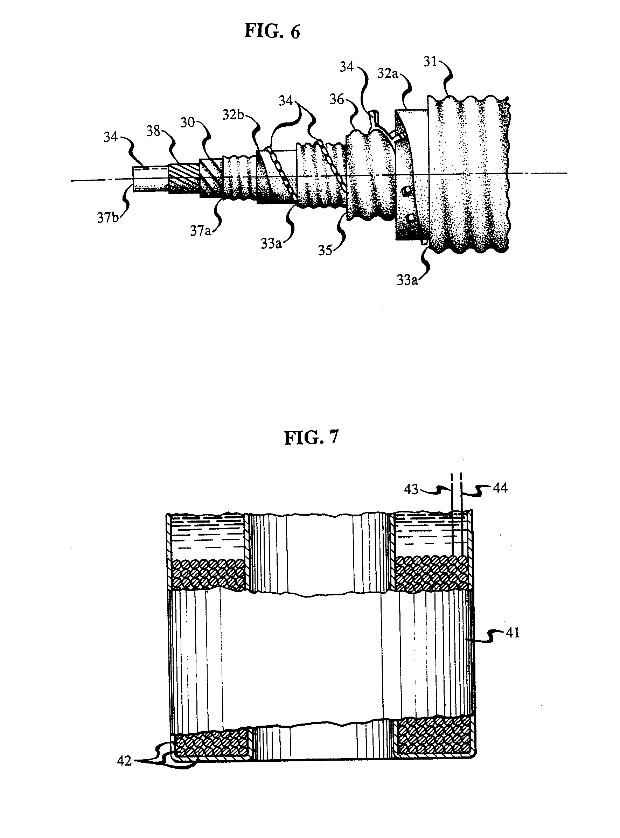

In FIG. 6, the structure shown is described in detail in G. Bogner, "Large Scale Applications of Superconductivity", in *Superconductor Applications: SQUIDS and Machines,* B. B. Schwartz and S. Foner, eds (Plenum Press, New York, 1977). Briefly, structure depicted consists of an outer sheathing 31, thermal insulation layers 32a and 32b, evacuated annular regions 33a and 33 b, spacers 34, nitrogen-filled annular region 35, heat shield 36, and coolant regions 37a and 37 b (it is a feature of the inventive structure that coolant may consist of liquid hydrogen in contradistinction with the liquid helium required of earlier structures). Element 38 is a superconductor material in accordance with the invention.

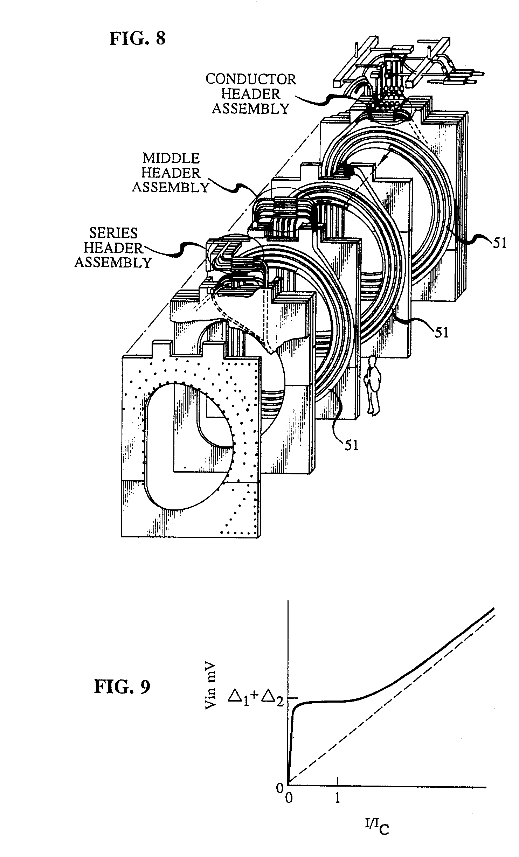

FIG. 7 shows an annular cryostat 41 filled with liquid hydrogen and containing turns 42 of a material herein. Terminal leads 43 and 44 are shown emerging from the coil. Magnetic test structure of FIG. 8 is described in R. A. Hein and D. U. Gubser, "Applications in the United States", in *Superconductor Materials Science: Metallurgy, Fabrication, and Applications,* S. Foner and B. B. Schwartz, eds., (Plenum Press, New York, 1981). The superconducting element shown as windings 51 are made of a material herein. The structure is considered exemplary of those expected to find broad-scale use for containment of fusion reaction.

FIGS. 9 and 10 depict the IV characteristic (FIG. 9) of the Josephson junction device shown schematically in FIG. 10. The structure consists of two superconducting layers 61 and 62 separated by a tunneling barrier 63. Use of material of the invention (not necessarily identical) for 61 and 64 permit usual Josephson action at higher temperatures than previously permitted. Josephson junction devices are described in M. R. Beasley and C. J. Kircher "Josephson Junction Electronics: Materials Issues and Fabrication Techniques", ibid.

## Claims

1. Superconducting element comprising a body characterised by at least one composition of the formula $La_{2-x}M_xCuO_{4-\delta}$ in which M is at least one element selected from the group consisting of Ba, Sr and Ca having lattice constants at least 2 parts in 1300 less than

$$\frac{a_o + b_o}{2} = 3.8 \text{ A},$$

$c_o = 13.29$, in which $x$ is from 0.05 to 1,2 and $\delta$ is from 0 to 0.5.

2. Superconducting element of claim 1, characterised in that the said lattice constants are as measured at a temperature of 23°C.

3. Superconducting element of claim 2, characterised in that $M$ contains at least one element selected from the group consisting of Sr and Ca.

4. Superconducting element of claim 3, characterised in that $M$ consists substantially of Sr and Ca.

5. Superconducting element of claim 2, characterised in that the body comprises a composition of the formula $La_{2-x-y}M'_yM_xCuO_{4-\delta}$ in which $y$ is up to 0.5.

6. Superconducting element of claim 5, characterised in that M' is at least one element selected from the group consisting of Pr, Y, and Bi.

7. Superconducting element of claim 6, characterised in that M' is at least one element selected from the group consisting of Pr and Y and y = from 0.05 to 0.5.

8. Superconducting element of claim 3, characterised in that the room temperature structure of the said composition is substantially tetragonal.

9. Superconducting element of claim 8, characterised in that the said structure is orthorhombic as measured below $T_c$.

10. Superconducting element of claim 3, characterised in that $x$ between 0.1 and 0.3.

11. Superconducting element of claim 10, characterised in that $\delta$ is a maximum of 0.15.

12. Superconducting element of claim 5, characterised in that the body ccomprises a composition of the formula $La_{2-x-y}M'_yM_xCu_{1-z}M''_zO_{4-\delta}$ in which $z$ is at least 0.01 and M'' is Sn.

13. Apparatus which depends for its operation upon superconducting current which includes an element, characterised in that the element is as claimed in any one of claims 1 through 12.

14. Magnetic apparatus which in operation produces a magnetic field by virtue of superconducting current characterised in that the apparatus includes an element as claimed in any one of claims 1 through 12.

15. Transmission line for carrying electrical power by means of passage of superconducting current, characterised in that the path for such current is defined by an element as claimed in any one of claims 1 through 12.

16. Apparatus whose operation depends upon alteration on current passage attributable to the state of superconductivity characterised in that the apparatus includes at least one element as claimed in any one of claims 1 through 12.

**FIG. 1**

**FIG. 10**

**FIG. 2**

**FIG. 3**

## FIG. 4

H=8.7 Oe

ZERO FIELD
COOLED

MAGNETIZATION ($10^{-3}$ emu)

TEMPERATURE (K)

## FIG. 5

MAGNETIZATION (ARB UNITS)

TEMPERATURE (K)

0274421

**FIG. 6**

**FIG. 7**

0274421

**FIG. 8**

CONDUCTOR
HEADER
ASSEMBLY

MIDDLE
HEADER
ASSEMBLY

SERIES
HEADER
ASSEMBLY

51

51

51

**FIG. 9**

$V_{in}$ mV

$\triangle_1 + \triangle_2$

0

0    1

$I/I_C$